# FASCICULE DE BREVET EUROPEEN

(11) **EP 0 967 662 B1**
(45) Date de publication et mention de la délivrance du brevet: **02.05.2007**
(21) Numéro de dépôt: 99401373.8
(22) Date de dépôt: 08.06.1999
(51) Int. Cl.: H01L 31/0352

(54) **Détecteur à puits quantique avec couche de stockage des électrons photoexcites**
Quantumwell-Detektor mit Speicheranordnung für photoangeregte Elektronen
Quantum well detector with a storage well for photoexited electrons

(30) Priorité: 23.06.1998 FR 9807914
(43) Date de publication de la demande: 29.12.1999
(73) Titulaire: Thales, 75008 Paris (FR)
(72) Inventeur: Berger, Vincent, Thomson-CSF P.I.D.B, 94117 Arcueil Cédex (FR); Bois, Philippe, Thomson-CSF P.I.D.B, 94117 Arcueil Cédex (FR)

(56) Documents cités:
- EP-A- 0 422 990
- EP-A- 0 557 186
- GOOSSEN K W ET AL: "PHOTOVOLTAIC QUANTUM WELL INFRARED DETECTOR" APPLIED PHYSICS LETTERS, vol. 52, no. 20, 16 mai 1988 (1988-05-16), pages 1701-1703, XP000098008 ISSN: 0003-6951
- VINTER B: "Detectivity of a three-level quantum-well detector" IEEE JOURNAL OF QUANTUM ELECTRONICS, JAN. 1994, USA, vol. 30, no. 1, pages 115-118, XP002095260 ISSN 0018-9197
- DUBOZ J Y ET AL: "EFFECT OF ASYMMETRIC BARRIERS ON PERFORMANCES OF GAAS/ALGAAS QUANTUM WELL DETECTORS" JOURNAL OF APPLIED PHYSICS, vol. 78, no. 4, 15 août 1995 (1995-08-15), pages 2803-2807, XP000541323

## Description

Le domaine de l'invention est celui des détecteurs d'onde électromagnétique réalisés avec des matériaux semiconducteurs III-V de manière à définir des structures à puits quantiques.

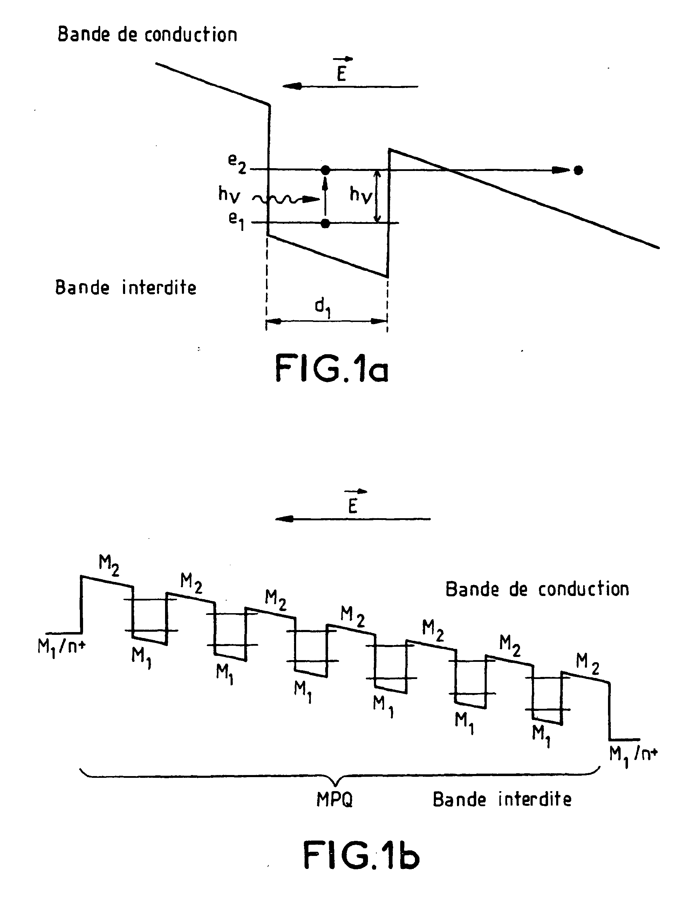

Le fonctionnement de tels détecteurs est basé sur l'occurrence de transitions électroniques entre niveaux permis d'énergie (e₁ et e₂) au sein de la bande de conduction de structures quantiques semiconductrices. La figure 1a donne un exemple de ce type de transition dans un puits présentant deux niveaux discrets d'énergie permise pour les électrons. L'application d'un champ électrique à ce type de configuration permet d'extraire du puits de manière préférentielle les électrons situés sur le deuxième niveau quantique. Ainsi, la collection dans le circuit électrique extérieur de ces électrons provenant du deuxième niveau quantique sur lequel ils ont été portés par un éclairement hν, permet la détection de ce dernier.

Pour obtenir une absorption importante de l'éclairement à détecter, on peut utiliser un grand nombre de puits au sein des détecteurs basés sur ce principe quantique. La figure 1b illustre une telle configuration à puits multiples.

Le problème rencontré avec les structures de l'art antérieur, décrites ci-dessus, réside dans le taux important de recombinaison de porteurs, notamment du à une couche barrière entre puits successifs, de faible épaisseur, voisine de celle des puits quantiques.

Des variantes photovoltaïques de ces détecteurs ont été proposées dans la littérature [Borge VINTER « Detectivity of a three level quantum well detector », IEEE Journal of Quantum Electronics, Vol 30, p. 115 (1994)]. Le document EP-A-0557186 décrit un détecteur photoélectrique à puits quantique. Le document J.Y. Duboz et al., Journal of Applied Physics 78,2803 (1995) décrit un détecteur avec barrières asymétriques.

Le problème rencontré avec des structures de l'art antérieur, décrites ci-dessus, réside dans le taux important de recombinaison de porteurs.

Cette recombinaison limite les performances de ces détecteurs et en particulier leur température de fonctionnement.

Dans le cas photovoltaïque, cette limitation est due à une couche barrière de trop faible épaisseur, entre les deux puits voisins constituant la structure photovoltaïque.

Pour limiter notablement le taux de recombinaison des porteurs, l'invention propose d'introduire dans le détecteur, une couche de stockage différente de la couche absorbante (puits quantique) et ce à l'aide d'une barrière de transfert de largeur importante par rapport à celle du puits quantique. En séparant ainsi la fonction d'absorption (dans le puits quantique) et la fonction de lecture des photoporteurs (dans une couche de stockage), on améliore les performances des détecteurs en évitant les recombinaisons de porteurs.

Pour permettre l'écoulement des électrons photoexcités dans la couche de stockage, la barrière de transfert présente un profil de potentiel de conduction, décroissant à partir du puits quantique.

Plus précisément, l'invention a pour objet un détecteur d'ondes électromagnétiques comprenant un empilement de couches en matériaux semiconducteurs III-V, le profil de bande de conduction desdits matériaux définissant au moins un puits quantique, ledit puits quantique présentant au moins un premier niveau discret d'énergie peuplé d'électrons capables de passer à un second niveau d'énergie sous l'absorption d'une onde électromagnétique et des moyens de lecture desdits électrons dans le second niveau d'énergie caractérisé en ce que l'empilement de couches en matériaux semiconducteurs comprend en outre, une couche de stockage d'électrons séparée du puits quantique, par une couche barrière de transfert, l'épaisseur de la couche barrière de transfert étant environ d'un ordre de grandeur supérieur à l'épaisseur du puits quantique, le niveau énergétique inférieur de la bande de conduction de la couche barrière de transfert étant supérieur à ceux du puits quantique et de la couche de stockage d'électrons et décroissante même en l'absence de tension appliqué, depuis le puits quantique jusqu'à la couche de stockage d'électrons de manière à favoriser l'écoulement des électrons depuis le second état d'énergie jusque dans la couche de stockage d'électrons.

Ainsi le détecteur de l'invention comprend :
- un puits quantique présentant une absorption intersousbande à l'énergie désirée, cette couche étant tout à fait similaire aux puits quantiques utilisés habituellement dans les détecteurs à puits quantiques [B. Levine « Quantum Well lnfrared Photodetectors », Journal of Applied Physics, volume 74, n° 8, R1. (1993)];
- une barrière de transfert qui se comporte comme une perte de potentiel dans laquelle les électrons photoexcités peuvent être transférés ;
- une couche de stockage des électrons photoexcités ;
- des moyens de lecture du photosignal.

Selon une première variante de l'invention, la barrière de transfert peut être composée d'un alliage semiconducteur dont la composition varie le long de l'épaisseur de ladite barrière de manière à ce que le potentiel de conduction décroisse quand on s'éloigne du puits.

Selon une seconde variante de l'invention, la barrière de transfert peut être élaborée avec un matériau piézoélectrique qui génère un champ électrique naturel, permettant de conférer au potentiel de conduction de la barrière de transfert, le profil requis.

Selon une troisième variante de l'invention, la structure semiconductrice peut également être mise directement sous champ électrique pour obtenir le profil de potentiel de conduction désiré, pour la barrière de transfert.

Par ailleurs, la lecture du signal de photodétection peut être effectuée de différente manière.

Il peut s'agir notamment d'une mesure de photocourant parallèle, utilisant des contacts ohmiques contactant la couche de stockage sans contacter le puits quantique absorbant.

Il peut également s'agir d'une lecture photovoltaïque de la tension due à l'espacement entre les électrons dans la couche de stockage et la couche du puits absorbant.

L'invention sera mieux comprise et d'autres avantages apparaîtront à la lecture de la description qui va suivre, donnée à titre non limitatif et grâce aux figures annexées parmi lesquelles :
- la figure 1a schématise un dispositif de détection d'ondes électromagnétiques comprenant un puits quantique, selon l'art connu;
- la figure 1b schématise une structure multipuits quantiques utilisée dans des dispositifs de détection selon l'art connu ;
- la figure 2 illustre un empilement de couches semiconductrices utilisé dans un détecteur selon l'invention ;
- la figure 3 illustre le profil des bandes de conduction de l'empilement de couches précité ;
- la figure 4 illustre un premier exemple de moyens de lecture des électrons photoexcités dans une mesure de photocourant parallèle dans un détecteur selon l'invention ;
- la figure 5 illustre un second exemple de moyens de lecture des électrons photoexcités dans une mesure de photocourant parallèle dans un détecteur selon l'invention ;
- la figure 6 illustre le profil modifié des bandes de conduction de l'empilement de couches illustré en figure 3, tenant compte des effets de charge d'espace ; la modification de ce profil provenant du transfert d'une population d'électrons du puits quantique vers la couche de stockage ;
- la figure 7 illustre un exemple de moyens de lecture des électrons photoexcités dans une mesure photovoltaïque dans un détecteur selon l'invention ;
- la figure 8 illustre un détecteur selon l'invention comprenant des moyens de lecture dans une mesure de photocourant parallèle et des moyens de remise à zéro du détecteur ;
- la figure 9 illustre un deuxième exemple de profil de bande de conduction utilisé dans un empilement de couches d'un détecteur selon l'invention ;
- la figure 10 illustre un troisième exemple de profil de bande de conduction utilisé dans un empilement de couches d'un détecteur selon l'invention ;
- la figure 11 illustre un quatrième exemple de profil de bande de conduction utilisé dans un empilement de couches d'un détecteur selon l'invention.

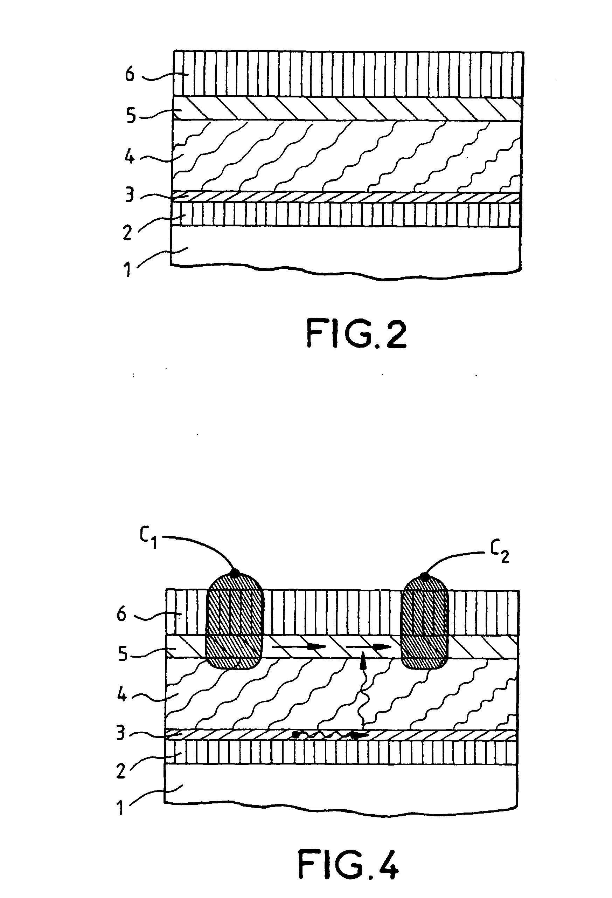

De manière générale, le détecteur selon l'invention comprend un empilement de couches semiconductrices comportant notamment comme l'illustre la figure 2 :
- un substrat 1 ;
- une première couche d'arrêt 2 pour confiner les électrons dans le puits quantique ;
- une couche constitutive du puits quantique 3 ;
- une couche de barrière de transfert à profil de bande de conduction inclinée, 4;
- une couche de stockage d'électrons photoexcités 5 ;
- une deuxième couche d'arrêt 6.

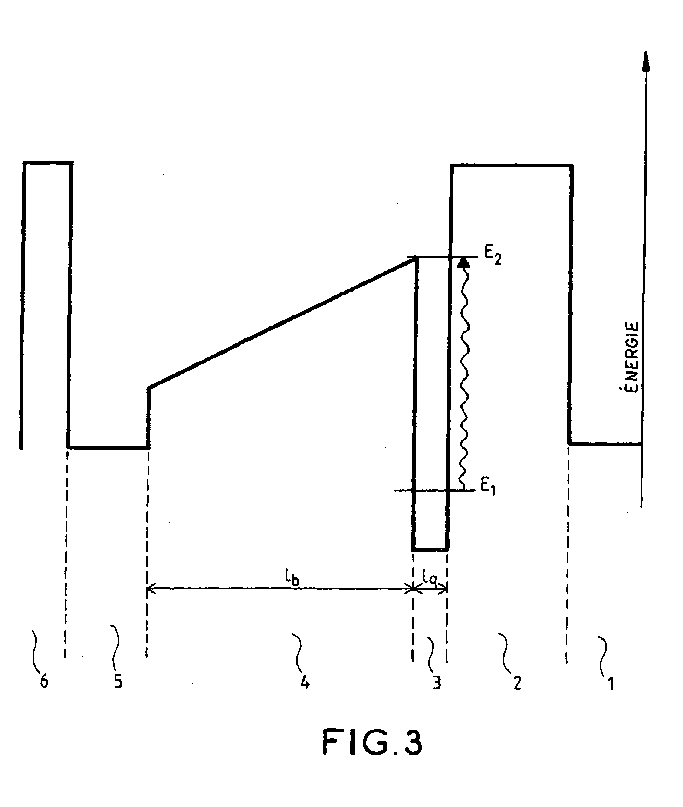

La figure 3 illustre le profil de bandes de conduction de l'empilement de couche précité ;

Typiquement, il existe un ordre de grandeur entre la largeur du puits quantique I_{q} et la largeur de la barrière de transfert I_{b}, pour éviter les recombinaisons possibles des électrons photoexcités.

En effet, la barrière de transfert étant très épaisse, les électrons étant capturés dans la couche de stockage y restent très longtemps (de quelques µs à quelques ms). Le retour à l'équilibre des porteurs dans le puits quantique par effet tunnel est en effet très long à travers la barrière de transfert de grande épaisseur (on peut choisir une épaisseur de plusieurs centaines de nanomètres si on le désire). Le gain de photoconductivité est donc très élevé si l'on compare ce temps à la durée de vie des électrons photoexcités dans les détecteurs à puits quantiques classiques (de l'ordre de la ps).

Pour effectuer la lecture du signal de photodétection, il est possible d'utiliser deux méthodes que nous allons décrire ci-après.

### 1ère méthode : mesure du photocourant parallèle

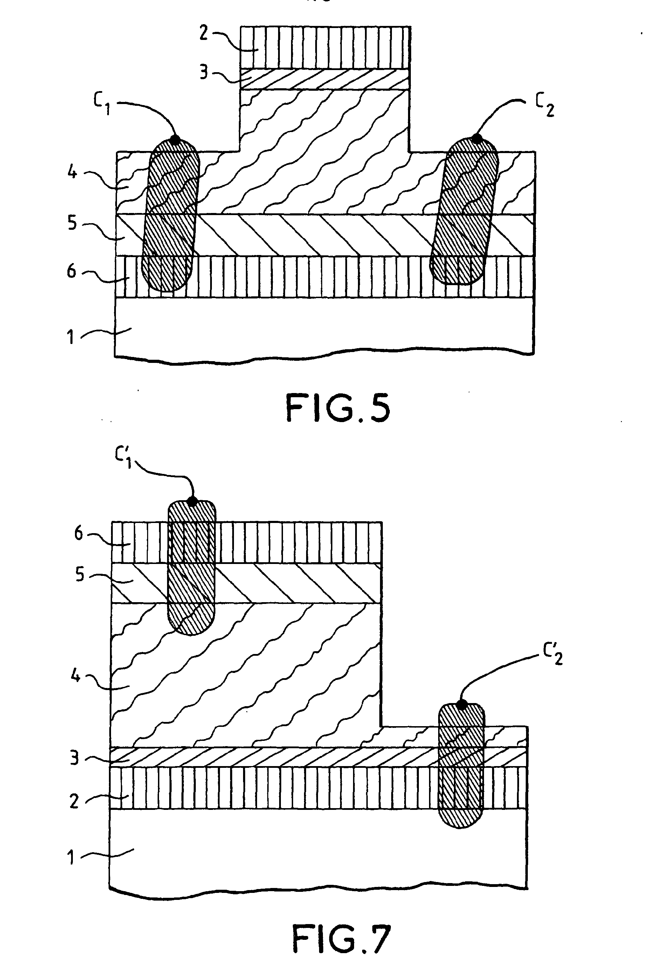

Cette mesure est effectuée dans le plan de la couche de stockage d'électrons. Pour cela, des premier et second contacts ohmiques contactent la couche de stockage sans contacter le puits quantique absorbant comme l'illustre la figure 4, qui reprend l'empilement de couches de matériaux semiconducteurs illustré en figure 2, et qui fait figurer les contacts ohmiques C₁ et C₂. Les flèches illustrent le cheminement des électrons et leur écoulement depuis le puits quantique 3 jusque dans la couche de stockage 5 dans laquelle ils sont collectés grâce aux contacts C₁ et C₂. Ceci suppose que l'épaisseur de la barrière de transfert est suffisamment grande pour que la diffusion du contact ohmique contacte la couche de stockage sans atteindre le puits quantique absorbant. Ce photocourant est proportionnel au nombre d'électrons capturés, et le temps pour le lire est très long si l'on compare avec les détecteurs à puits quantiques classiques. La couche de stockage étant non dopée, le courant est très faible sans éclairement de la structure puisque cette couche contient très peu de porteurs à l'équilibre thermodynamique. L'éclairement de la structure envoie des électrons sur le niveau excité E₂ du puits quantique absorbant, une partie de ceux-ci transitent vers la couche de stockage via la barrière de transfert. La conductivité de la couche de stockage s'accroît alors énormément. On a donc conceptuellement un transistor contrôlé optiquement : La couche de stockage est le canal, le rôle de la grille est joué par le faisceau optique à détecter, et la source et le drain sont les deux électrodes entre lesquelles est lu le photocourant. Il faut ici insister sur l'importance capitale que les contacts ohmiques n'atteignent pas le puits absorbant. On sait par diffusion de dopants faire des contacts qui atteignent la couche de stockage sans toucher au puits absorbant pour une barrière de transfert séparant les deux couches aussi fine que 500Å.

Une autre géométrie de contacts consiste à réaliser une mesa par une technologie tout à fait standard, et venir ensuite contacter la couche de stockage en dessous du puits quantique. Dans ce cas, lors de la croissance, l'ordre des couches a été inversé par rapport à la solution précédente. Cette solution a l'avantage de ne pas nécessiter la maîtrise de la profondeur du contact. Le schéma est représenté à la figure 5 ; la fonction de transistor contrôlé optiquement apparaît plus clairement.

### Estimation du photocourant au bout de 10 ms de stockage :

Avec un flux typique de 10¹⁶ photons.cm⁻².s⁻¹, et une absorption de 5% dans le puits quantique unique (chiffre courant pour un puits quantique muni d'un réseau de diffraction en surface), on a placé sur le niveau E₂ (état excité) environ 5.10¹⁴ électrons/cm⁻² et par seconde. Si l'on suppose une probabilité 1/2 pour un électron de partir dans la barrière de transfert pour atteindre la couche de stockage (contre une probabilité 1/2 de retomber sur le niveau fondamental du puits et donc de ne servir à rien pour la photodétection), cela mène, pendant 10ms de temps d'intégration, à 2.5.10¹²cm⁻² électrons transférés dans la couche de stockage.

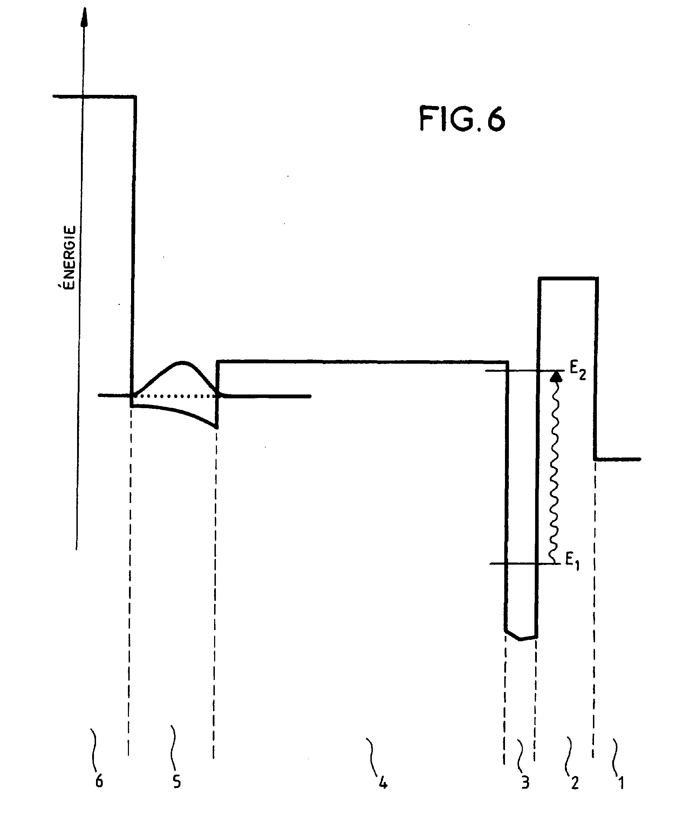

En réalité ce modèle est trop simpliste et il nous faut absolument tenir compte des effets de charge d'espace dans cette structure où les électrons sont transférés loin des atomes dopants. Les effets de charge d'espace mènent à un champ induit dans la barrière de transfert, et celle-ci cessera de transférer les porteurs quand ce champ induit compensera la pente de potentiel existant naturellement dans la barrière de transfert. A cause de ces effets de charge d'espace, la structure de bande est déformée et passe de celle représentée figure 3 à celle représentée figure 6.

Pour calculer le nombre maximum de porteurs transférables dans la couche de stockage, on écrit l'équilibre entre le champ dû aux effets de charge d'espace et le pente de potentiel dans la barrière de transfert, sans porteurs transférés. Pour une barrière comme celle de la figure 2, cela mène à une pente de potentiel égale à 180meV/500Å=36kV/cm.

Le champ dû aux effets de charge d'espace est égal à E = ρ_{S} e / ε₀εᵣ, où ρ_{S} est la densité d'électrons transférés. En égalant les deux quantités, on déduit que ρₛ est de l'ordre de 2.5 10¹¹ cm⁻².

Compte tenu des calculs précédents, on voit que la couche de stockage a été remplie au bout d'un temps d'intégration d'environ 500µs pour les niveaux d'éclairements donnés ci-dessus.

La couche de stockage présente alors une résistance électrique (pour une surface standard de pixel utilisé dans les détecteurs, égale à 30µm*30µm) de R = L/NqµS = 250 Ω. Pour cela on a pris une mobilité de µ=10⁵ cm2V⁻¹s⁻¹, ce qui est courant pour des canaux de transistor en GaAs à 77K. Cette résistance, très faible, correspond donc à un photocourant de 40µA pour une polarisation de 1mV entre la source et le drain. Ces photocourants sont largement supérieurs aux photocourants des détecteurs à puits quantiques habituels, en raison de l'augmentation du gain de photoconductivité.

### 2ème méthode : mesure photovoltaïque

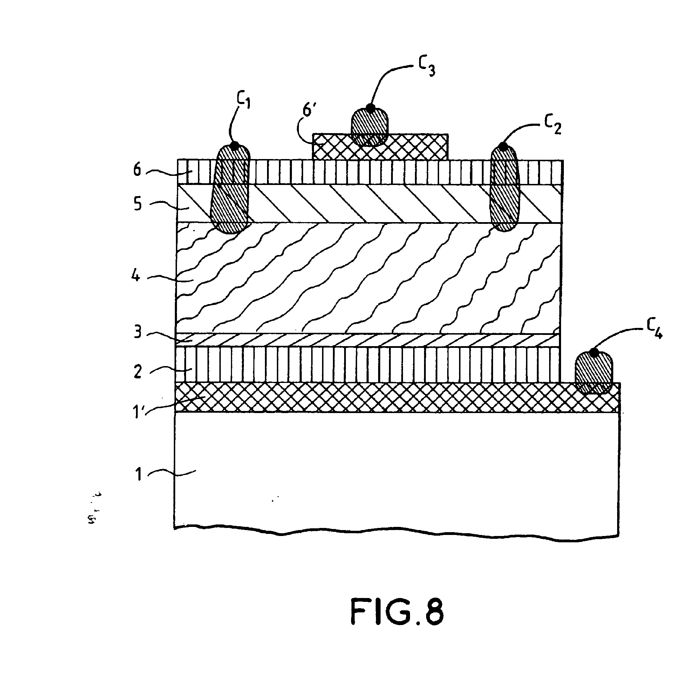

Dans ce cas, on mesure la tension due à l'espacement entre les électrons dans la couche de stockage et la couche du puits absorbant, qui est dopé et ce grâce à deux contacts ohmiques pris respectivement au niveau de la couche de stockage (contact C'₁) et au niveau du puits quantique (contact C'₂) comme l'illustre la figure 7. On lit directement la tension, qui sera comprise entre 0 et 180 mV dans le cas d'une barrière dont le pourcentage d'Al varie de 30% à 8% dans un alliage AlₓGa₁₋ₓAs. Il faut noter que la valeur maximale de la tension ne dépend pas de la largeur de la couche de stockage. L'effet de cette largeur est surtout la modification du temps de retour à l'équilibre des électrons.

On mesurera la tension maximale de 180 mV (c'est à dire qu'on sera à saturation) pour un flux typique de 10¹⁶ photons.cm- 2 pendant un temps d'intégration de 500µs environ. Un temps d'intégration de 30ms permet d'obtenir une tension de 180mV pour un flux de photons très faible : 2.10¹⁴ photons.cm- 2 seulement.

Ce type de détecteur sera donc particulièrement bien adapté à la détection dans une zone spectrale où il y a peu de photons, comme la zone 3-5 µm pour l'imagerie infrarouge de corps noirs à 300 K.

La détectivité supérieure de ce type de détecteur photovoltaïque par rapport au détecteurs photovoltaïques à puits quantiques décrits précédemment dans la littérature [B. Vinter, « Detectivity of a three-level quantum well detector », IEEE J. of Quantum Electronics, Vol. 30, p. 115 (1994)] provient de deux avantages spécifiques.
1) Un taux de capture efficace dans la couche de stockage: Une forte proportion des porteurs (par exemple la moitié) sont transférés dans la couche de stockage, grâce à la pente de potentiel présente dans la barrière de transfert. Cette pente de potentiel joue ici un rôle crucial, c'est elle qui permet d'avoir un bon transfert. En effet, grâce à cette pente de potentiel, les électrons ne peuvent pas remonter et revenir et se recombiner dans le puits absorbant.
2) Un temps de retour à l'équilibre long: La barrière de transfert est très épaisse (par exemple 500Å), ce qui augmente le temps de retour des porteurs depuis leur niveau métastable dans la couche de stockage jusqu'à leur état d'équilibre dans le puits quantique. Le gain est ainsi augmenté.

Dans tous les cas, une tension perpendiculaire peut être appliquée au dispositif pour forcer les électrons à revenir dans le puits quantique absorbant si l'on désire initialiser le système entre deux mesures.

Dans le cas de la première méthode de lecture photoconductive, il faut rajouter deux couches dopées n+, 1' et 6' au niveau de l'empilement des couches (2 **→** 6) illustré en figures 4, 5 et 7, une sur le dessus et une autre en dessous de la structure. On obtient alors un dispositif a quatre contacts C₁, C₂, C₃, C₄ comme illustré en figure 8

Dans le cas de la seconde méthode de lecture photovoltaïque, on peut rester avec le schéma de la figure 7, et on garde deux contacts seulement. On se sert des deux contacts pour la lecture de la tension et pour l'initialisation du système.

Ce principe d'initialisation peut être utilisé pendant la lecture pour régler le niveau désiré du nombre d'électrons dans la couche de stockage. Cela permet par exemple de régler l'énergie potentielle dans la couche de stockage avec un offset tel que la population d'électrons est faible sous un éclairement donné. Grâce à cet offset, le détecteur ne lie que les variations d'éclairement par rapport au niveau moyen d'éclairement, ce qui est très intéressant quand le détecteur analyse une scène infrarouge moyen à température ambiante.

Signalons qu'un certain nombre de possibilités peuvent être utilisées avec les détecteurs décrits ici, elles n'ont pas été décrites car elles ne sont pas caractéristiques de l'invention. Citons simplement les réseaux de diffraction gravés sur le dessus du détecteur pour coupler la lumière incidente à la transition intersousbande du puits absorbant et obtenir ainsi une absorption maximale (ceci est très classique dans la littérature).

Nous allons décrire plus en détail des exemples de structures d'empilement pouvant être utilisées dans des détecteurs selon l'invention.

Premier exemple d'empilement de couches semiconductrices pouvant être utilisé dans l'invention, dont le profil de bande de conduction correspond à celui illustré en figure 3.

Il s'agit d'une configuration dans laquelle la barrière de transfert est constituée d'un alliage dont la composition varie le long de l'épaisseur pour obtenir le profil désiré au niveau du potentiel de conduction de la barrière de transfert.

Selon cet exemple :
- le substrat 1 est en GaAs, par exemple non dopé ;
- la couche d'arrêt 2 est en Al_{0,44}Ga_{0,56}As, d'épaisseur 300 Å;
- le puits quantique présentant deux niveaux discrets d'énergie E₁ et E₂ est en In_{0,15}Ga_{0,85}As et typiquement une épaisseur lq = 30 Å ;
- la barrière de transfert est réalisée avec l'alliage Al_{y}Ga_{1-y}As d'épaisseur 500 Å, le pourcentage y variant linéairement de 0,3 à 0,08, à partir du puits quantique permettant d'obtenir une chute de potentiel variant de 250 meV à 70 meV par rapport au bas de la bande de conduction de GaAs ;
- la couche de stockage 5 est réalisée avec du GaAs et présente une épaisseur de 150 Å;
- la couche 6 est en Al_{0,44}Ga_{0,56}As identique à la première couche d'arrêt 2.

Ainsi lors d'une absorption de transition optique à détecter les électrons situés sur le niveau d'énergie E₁, passent sur le niveau d'énergie E₂ pour être ensuite évacués via la barrière de transfert, dans la couche de stockage, dans laquelle ils peuvent s'accumuler.

Dans cet exemple, le puits quantique possède un second niveau discret d'énergie E₂. Il est également possible d'utiliser une structure dans laquelle le puits quantique ne comprend qu'un unique niveau discret d'énergie. La transition optique peut alors avoir lieu entre le niveau d'énergie E₁ et le continuum de niveaux au-dessus de la barrière comme cela est connu dans l'art antérieur.

### Deuxième exemple d'empilement de couches semiconductrices

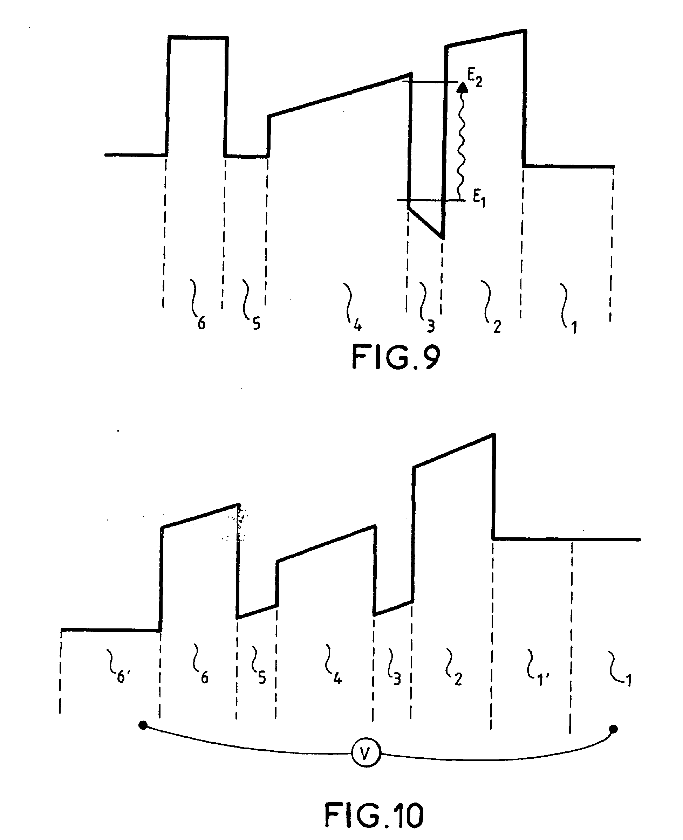

Le détecteur peut être obtenu avec un empilement de couches de matériaux semiconducteurs comprenant un matériau semiconducteur dans lequel règne naturellement un champ électrique d'origine piézoélectrique. Par exemple, un tel matériau peut être constitué d'un puits quantique en In_{0,2}Ga_{0,8}As sur substrat GaAs (111). Le champ piézoélectrique présent dans le puits quantique contraint de l'ordre de 100 kV/cm a pour conséquence l'apparition de champ électrique également dans les barrières, comme le montre la figure 9 représentant l'empilement de couches suivantes, utilisé dans un deuxième exemple de détecteur
Substrat 1: GaAs (111)
Couche d'arrêt 2 : Al_{0,44}Ga_{0,56}As et épaisseur = 500 Å
Puits quantique 3 : Ga_{0,8}In_{0,2}As avec Iq = 40 Å
Barrière de transfert 4 : Al_{0,22}Ga_{0,78}As épaisseur = 500 Å
Couche de stockage 5 : GaAs ls = 100 Å
Couche d'arrêt 6 : Al_{0,44}Ga_{0,56}As et épaisseur = 500 Å

Troisième exemple d'empilement de couches semiconductrices dont le profil de bande de conduction est illustré en figure 10.

L'empilement de couches semiconductrices de l'invention est inséré entre deux couches de contact ohmiques pour appliquer une tension V qui permet de conférer le profil requis à la barrière de transfert. Selon cet exemple, on a donc l'empilement de couches semiconductrices suivant :
substrat 1 : GaAs
Couche contact 1' : GaAs dopé n+ épaisseur = 3 000 Å
Couche d'arrêt 2 : Al_{0,44}Ga_{0,56}As épaisseur = 500 Å
Puits quantique 3 : In_{0,15}Ga_{0,85}As, Iq = 35 Å
Couche barrière de transfert 4 : Al_{0,22}Ga_{0,78}As, I_{b} = 500 Å
Couche de stockage 5 : GaAs épaisseur = 100 Å
Couche d'arrêt 6 : Al_{0,44}Ga_{0,56}As épaisseur = 500 Å
Couche de contact 6': GaAs dopé n+ épaisseur = 1 000 Å

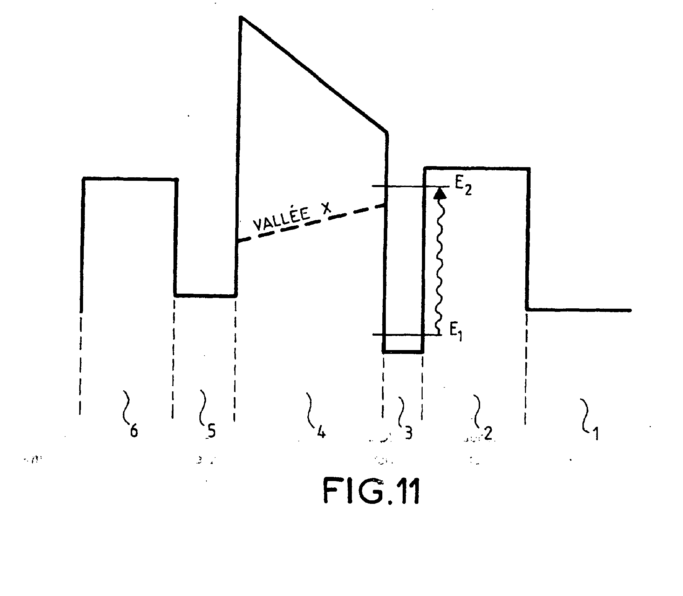

Quatrième exemple d'empilement de couches semiconductrices dont le profil de bande de conduction est illustré en figure 11.

Cet exemple d'empilement de matériaux semiconducteurs comprend un matériau constitutif de la barrière de transfert composé d'un alliage dont la composition varie et dans lequel le transport des électrons peut s'effectuer via les vallées X comme illustré en figure 11. Ce type de comportement est obtenu notamment avec un alliage de AlₓGa₁₋ₓAs, pour lequel le pourcentage x croît de 0,44 à 1. Dans ce cas, le niveau des vallées X dans le matériau chute d'environ 320 meV dans le matériau Al_{0,5}Ga_{0,5}As à environ 200 meV dans le matériau AlAs, par rapport au bas de la bande de conduction. Dans cet exemple, le substrat, les couches d'arrêt de puits quantique et la couche de stockage peuvent être identiques à ceux de l'exemple 1.

## Revendications

1. Détecteur d'ondes électromagnétiques comprenant un empilement de couches en matériaux semiconducteurs III-V, le profil de bande de conduction desdits matériaux définissant au moins un puits quantique (3) présentant au moins un premier niveau discret d'énergie (E₁) peuplé d'électrons capables de passer à un second niveau d'énergie (E₂) sous l'absorption d'une onde électromagnétique et des moyens de lecture desdits électrons dans le second niveau d'énergie **caractérisé en ce que** l'empilement de couches en matériaux semiconducteurs comprend en outre, une couche de stockage d'électrons (5) séparée du puits quantique (3), par une couche barrière de transfert (4) l'épaisseur de la couche barrière de transfert étant environ d'un ordre de grandeur supérieur à l'épaisseur du puits quantique, le niveau énergétique inférieur de la bande de conduction de la couche barrière de transfert étant supérieur à ceux du puits quantique et de la couche de stockage d'électrons et décroissante même en l'absence de tension appliquée, depuis le puits quantique jusqu'à la couche de stockage d'électrons de manière à favoriser l'écoulement des électrons depuis le second état d'énergie jusque dans la couche de stockage d'électrons.

2. Détecteur d'ondes électromagnétiques selon la revendication 1, **caractérisé en ce que** l'empilement de couches en matériaux semiconducteurs III-V comprend en outre une première et une seconde couches d'arrêt (2,6) en matériaux semiconducteurs tels que le niveau énergétique inférieur de leur bande de conduction sont respectivement supérieurs aux niveaux énergétiques inférieurs de bande de conduction du puits quantique (3) et de la couche de stockage d'électrons (5).

3. Détecteur d'ondes électromagnétiques selon l'une des revendications 1 ou 2, **caractérisé en ce que** le profil décroissant du niveau énergétique inférieur de la bande de conduction de la couche barrière de transfert (4) est obtenu avec un alliage semiconducteur dont la composition varie depuis le puits quantique jusqu'à la couche de stockage d'électrons (5).

4. Détecteur d'ondes électromagnétiques selon l'une des revendications 1 ou 2, **caractérisé en ce que** le profil décroissant du niveau énergétique inférieur de la bande de conduction de la couche barrière de transfert (4) est obtenu grâce à la présence dans l'empilement de couches en matériaux semiconducteurs, d'un matériau semiconducteur piézoélectrique créant un champ électrique naturel.

5. Détecteur d'ondes électromagnétiques selon l'une des revendications 1 ou 2, **caractérisé en ce que** l'empilement de couches en matériaux semiconducteurs comprend une première et une seconde couches en matériaux semiconducteurs dopés de part et d'autre de l'ensemble couche de stockage d'électrons/couche barrière de transfert/puits quantique de manière à pouvoir créer un champ électrique responsable du profil décroissant du niveau énergétique inférieur de la bande de conduction de la couche barrière de transfert.

6. Détecteur d'ondes électromagnétiques selon l'une des revendications 1 à 5, **caractérisé en ce que** les moyens de lecture des électrons dans le second niveau d'énergie comprennent un premier et un second contacts ohmiques (C₁,C₂) situes au niveau de la couche de stockage d'électrons de manière à effectuer une mesure de photocourant dans le plan de la couche de stockage (5).

7. Détecteur d'ondes électromagnétiques selon la revendication 5, **caractérisé en ce qu**'il comprend l'empilement suivant de couches de matériaux semiconducteurs à partir de la surface d'un substrat semiconducteur :
- une première couche d'arrêt (2);
- un puits quantique (3);
- une couche barrière de transfert (4);
- une couche de stockage d'électrons (5);
- une deuxième couche d'arrêt (6);
les premier et second contacts ohmiques (C₁,C₂) s'étendant depuis la deuxième couche d'arrêt jusque dans la couche de stockage d'électrons.

8. Détecteur d'ondes électromagnétiques selon la revendication 6, **caractérisé en ce qu**'il comprend l'empilement suivant de couches de matériaux semiconducteurs à partir de la surface d'un substrat semiconducteur :
- une deuxième couche d'arrêt (6);
- une couche de stockage d'électrons (5);
- une couche barrière de transfert (4);
- une couche de stockage d'électrons (5);
- une première couche d'arrêt (2);
et une mesa définie dans :
- la couche barrière de transfert (4);
- le puits quantique (3);
- la première couche d'arrêt (2);
les premier et second contacts ohmiques (C₁,C₂) étant situés de part et d'autre de la mesa.

9. Détecteur d'ondes électromagnétiques selon l'une des revendications 1 à 5, **caractérisé en ce que** les moyens de lecture des électrons dans le second niveau d'énergie comprennent un premier et un second contacts ohmiques (C₁C₂) situés respectivement au niveau du puits quantique (3) et au niveau de la couche de stockage d'électrons (5) de manière à effectuer une lecture photovoltaïque de la tension établie entre les électrons du puits quantique (3) et les électrons de la couche de stockage (5).

10. Détecteur d'ondes électromagnétiques selon la revendication 9, **caractérisé en ce qu'**il comprend l'empilement suivant de matériaux semiconducteurs à partir d'un substrat semiconducteur :
- une première couche d'arrêt (2);
- un puits quantique (3);
- une couche barrière de transfert (4);
- une couche de stockage d'électrons (5);
- une seconde couche d'arrêt (6);
et une gravure jusqu'au niveau de la couche barrière de transfert de manière à réaliser le premier contact ohmique s'étendant jusqu'au puits quantique (C'₂) et le second contact ohmique (C'₁) s'étendant jusqu'à la couche de stockage d'électrons.

11. Détecteur d'ondes électromagnétiques selon l'une des revendications 1 à 10, **caractérisé en ce qu**'il comprend en outre des moyens de remise à zéro de l'écoulement des électrons dans la couche de stockage (5).

12. Détecteur d'ondes électromagnétiques selon les revendications 6 et 11, **caractérisé en ce qu**'il comprend des troisième et quatrième contacts (C₃,C₄) situés de part et d'autre de l'empilement de couches de matériaux semiconducteurs.

## Claims

1. Electromagnetic wave detector comprising a multilayer stack made of III-V semiconductor materials, the conduction band profile of said materials defining at least one quantum well (3) having at least a first discrete energy level (E₁) populated with electrons capable of passing to a second energy level (E₂) by the absorption of an electromagnetic wave and means for reading said electrons in the second energy level, **characterized in that** the multilayer stack of semiconductor materials furthermore includes an electron storage layer (5) separated from the quantum well (3) by a transfer barrier layer (16), the thickness of the transfer barrier layer being approximately one order of magnitude greater than the thickness of the quantum well, the lower energy level of the conduction band of the transfer barrier layer being higher than those of the quantum well and of the electron storage layer, and decreasing, even in the absence of applied voltage, from the quantum well as far as the electron storage layer so as to promote the flow of electrons from the second energy state right into the electron storage layer.

2. Electromagnetic wave detector according to Claim 1, **characterized in that** the multilayer stack of III-V semiconductor materials further includes first and second stop layers (2, 6) made of semiconductor materials such that the lower energy levels of their conduction bands are respectively higher than the lower energy levels of the conduction band of the quantum well (3) and of the electron storage layer (5).

3. Electromagnetic wave detector according to either of Claims 1 and 2, **characterized in that** the decreasing profile of the lower energy level of the conduction band of the transfer barrier layer (4) is obtained with a semiconductor alloy whose composition varies from the quantum well to the electron storage layer (5).

4. Electromagnetic wave detector according to either of Claims 1 and 2, **characterized in that** the decreasing profile of the lower energy level of the conduction band of the transfer barrier layer (4) is obtained by the presence, in the multilayer stack of semiconductor materials, of a piezoelectric semiconductor material that creates a natural electric field.

5. Electromagnetic wave detector according to either of Claims 1 and 2, **characterized in that** the multilayer stack of semiconductor materials comprises first and second layers made of doped semiconductor materials on either side of the electron storage layer/transfer barrier layer/quantum well assembly, so as to be able to create an electric field responsible for the decreasing profile of the lower energy level of the conduction band of the transfer barrier layer.

6. Electromagnetic wave detector according to one of Claims 1 to 5, **characterized in that** the means for reading the electrons in the second energy level comprise first and second ohmic contacts (C₁, C₂) that are located on the electron storage layer so as to take a measurement of the photocurrent in the plane of the storage layer (5).

7. Electromagnetic wave detector according to Claim 5, **characterized in that** it comprises the following multilayer stack of semiconductor materials, starting from the surface of a semiconductor substrate:
- a first stop layer (2);
- a quantum well (3);
- a transfer barrier layer (4);
- an electron storage layer (5); and
- a second stop layer (6),
the first and second ohmic contacts (C₁, C₂) extending from the second stop layer right into the electron storage layer.

8. Electromagnetic wave detector according to Claim 6, **characterized in that** it comprises the following multilayer stack of semiconductor materials, starting from the surface of a semiconductor substrate:
- a second stop layer (6);
- an electron storage layer (5);
- a transfer barrier layer (4);
- an electron storage layer (5);
- a first stop layer (2);
and a mesa defined in:
- the transfer barrier layer (4);
- the quantum well (3); and
- the first stop layer (2),
the first and second ohmic contacts (C₁, C₂) being located on either side of the mesa.

9. Electromagnetic wave detector according to one of Claims 1 to 5, **characterized in that** the means for reading the electrons in the second energy level comprise first and second ohmic contacts (C₁, C₂) that are located, respectively, at the quantum well (3) and at the electron storage layer (5) so as to effect a photovoltaic read-out of the voltage established between the electrons in the quantum well (3) and the electrons in the storage layer (5).

10. Electromagnetic wave detector according to Claim 9, **characterized in that** it comprises the following stack of semiconductor materials, starting from a semiconductor substrate:
- a first stop layer (2);
- a quantum well (3);
- a transfer barrier layer (4);
- an electron storage layer (5); and
- a second stop layer (6),
and etching as far as the transfer barrier layer so as to produce the first ohmic contact (C'₂) extending into the quantum well and the second ohmic contact (C'₁) extending into the electron storage layer.

11. Electromagnetic wave detector according to one of Claims 1 to 10, **characterized in that** it further includes means for resetting the flow of electrons in the storage layer (5).

12. Electromagnetic wave detector according to Claims 6 and 11, **characterized in that** it includes third and fourth contacts (C₃, C₄) located on either side of the multilayer stack of semiconductor materials.

## Patentansprüche

1. Detektor für elektromagnetische Wellen, der eine Stapelung von Schichten aus Halbleitermaterialien III-V aufweist, wobei das Leitungsbandprofil der Materialien mindestens einen Quantentrog (3) definiert, der mindestens ein erstes diskretes Energieniveau (E₁) aufweist, das von Elektronen bevölkert wird, die in der Lage sind, unter der Absorption einer elektromagnetischen Welle auf ein zweites Energieniveau (E₂) überzugehen, und Mittel zum Lesen der Elektronen im zweiten Energieniveau aufweist, **dadurch gekennzeichnet, dass** die Stapelung von Schichten aus Halbleitermaterialien außerdem eine Schicht zum Speichern von Elektronen (5) aufweist, die vom Quantentrog (3) durch eine Transfersperrschicht (4) getrennt wird, wobei die Dicke der Transfersperrschicht etwa eine Größenordnung über der Dicke des Quantentrogs liegt, wobei das untere Energieniveau des Leitungsbands der Transfersperrschicht über denjenigen des Quantentrogs und der Elektronenspeicherschicht liegt und selbst in Abwesenheit einer angelegten Spannung vom Quantentrog bis zur Elektronenspeicherschicht abnimmt, um das Fließen der Elektronen vom zweiten Energiezustand bis in die Elektronenspeicherschicht zu begünstigen.

2. Detektor für elektromagnetische Wellen nach Anspruch 1, **dadurch gekennzeichnet, dass** die Stapelung von Schichten aus Halbleitermaterialien III-V außerdem derartige erste und zweite Randschichten (2, 6) aus Halbleitermaterialien aufweist, dass das untere Energieniveau ihres Leitungsbands jeweils höher ist als die unteren Leitungsband-Energieniveaus des Quantentrogs (3) und der Elektronenspeicherschicht (5).

3. Detektor für elektromagnetische Wellen nach einem der Ansprüche 1 oder 2, **dadurch gekennzeichnet, dass** das abnehmende Profil des unteren Energieniveaus des Leitungsbands der Transfersperrschicht (4) mit einer Halbleiterlegierung erhalten wird, deren Zusammensetzung vom Quantentrog bis zur Elektronenspeicherschicht (5) variiert.

4. Detektor für elektromagnetische Wellen nach einem der Ansprüche 1 oder 2, **dadurch gekennzeichnet, dass** das abnehmende Profil des unteren Energieniveaus des Leitungsbands der Transfersperrschicht (4) aufgrund des Vorhandenseins eines piezoelektrischen Halbleitermaterials in der Stapelung von Schichten aus Halbleitermaterialien erhalten wird, das ein natürliches elektrisches Feld erzeugt.

5. Detektor für elektromagnetische Wellen nach einem der Ansprüche 1 oder 2, **dadurch gekennzeichnet, dass** die Stapelung von Schichten aus Halbleitermaterialien eine erste und eine zweite Schicht aus dotierten Halbleitermaterialien zu beiden Seiten der Einheit aus Elektronenspeicherschicht, Transfersperrschicht und Quantentrog aufweist, um ein elektrisches Feld erzeugen zu können, das für das abnehmende Profil des unteren Energieniveaus des Leitungsbands der Transfersperrschicht verantwortlich ist.

6. Detektor für elektromagnetische Wellen nach einem der Ansprüche 1 bis 5, **dadurch gekennzeichnet, dass** die Mittel zum Lesen der Elektronen im zweiten Energieniveau einen ersten und einen zweiten ohmschen Kontakt (C₁, C₂) in Höhe der Elektronenspeicherschicht aufweisen, um eine Fotostrommessung in der Ebene der Speicherschicht (5) durchzuführen.

7. Detektor für elektromagnetische Wellen nach Anspruch 5, **dadurch gekennzeichnet, dass** er die folgende Stapelung von Schichten aus Halbleitermaterialien ausgehend von der Oberfläche eines Halbleitersubstrats aufweist:
- eine erste Randschicht (2);
- einen Quantentrog (3);
- eine Transfersperrschicht (4);
- eine Elektronenspeicherschicht (5);
- eine zweite Randschicht (6);
wobei der erste und der ohmsche Kontakt (C₁, C₂) sich von der zweiten Randschicht bis in die Elektronenspeicherschicht erstrecken.

8. Detektor für elektromagnetische Wellen nach Anspruch 6, **dadurch gekennzeichnet, dass** er die folgende Stapelung von Schichten aus Halbleitermaterialien ausgehend von der Oberfläche eines Halbleitersubstrats aufweist:
- eine zweite Randschicht (6);
- eine Elektronenspeicherschicht (5);
- eine Transfersperrschicht (4);
- eine Elektronenspeicherschicht (5);
- eine erste Randschicht (2);
und einen ebenen Bereich, der definiert ist in:
- der Transfersperrschicht (4);
- dem Quantentrog (3);
- der ersten Randschicht (2);
wobei der erste und der zweite ohmsche Kontakt (C₁, C₂) sich zu beiden Seiten des ebenen Bereichs befinden.

9. Detektor für elektromagnetische Wellen nach einem der Ansprüche 1 bis 5, **dadurch gekennzeichnet, dass** die Mittel zum Lesen der Elektronen im zweiten Energieniveau einen ersten und einen zweite ohmschen Kontakt (C₁, C₂) aufweisen, die sich in Höhe des Quantentrogs (3) bzw. in Höhe der Elektronenspeicherschicht (5) befinden, um ein fotovoltaisches Lesen der Spannung durchzuführen, die zwischen den Elektronen des Quantentrogs (3) und den Elektronen der Speicherschicht (5) aufgebaut ist.

10. Detektor für elektromagnetische Wellen nach Anspruch 9, **dadurch gekennzeichnet, dass** er die folgende Stapelung von Halbleitermaterialien ausgehend von einem Halbleitersubstrat aufweist:
- eine erste Randschicht (2);
- einen Quantentrog (3);
- eine Transfersperrschicht (4);
- eine Elektronenspeicherschicht (5);
- eine zweite Randschicht (6);
und eine Ätzung bis auf die Ebene der Transfersperrschicht, um den ersten ohmschen Kontakt (C'₂), der sich bis zum Quantentrog erstreckt, und den zweiten ohmschen Kontakt (C'₂) herzustellen, der sich bis zur Elektronenspeicherschicht erstreckt.

11. Detektor für elektromagnetische Wellen nach einem der Ansprüche 1 bis 10, **dadurch gekennzeichnet, dass** er außerdem Mittel zur Nullrückstellung des Fließens der Elektronen in der Speicherschicht (5) aufweist.

12. Detektor für elektromagnetische Wellen nach den Ansprüchen 6 und 11, **dadurch gekennzeichnet, dass** er dritte und vierte Kontakte (C₃, C₄) aufweist, die sich zu beiden Seiten der Stapelung von Halbleitermaterialien befinden.
